Europäisches Patentamt

European Patent Office

Office européen des brevets

(11) Publication number: **0 417 780 A2**

# EUROPEAN PATENT APPLICATION

(21) Application number: 90117648.7

(51) Int. Cl.5: **C23C 14/32, H01J 37/32**

(22) Date of filing: **13.09.90**

(30) Priority: **13.09.89 CS 5288/89**

(43) Date of publication of application:
**20.03.91 Bulletin 91/12**

(84) Designated Contracting States:
**BE CH DE GB LI NL**

(71) Applicant: **CESKOSLOVENSKA AKADEMIE VED**
**Narodni 3**
**Praha 1(CS)**

(72) Inventor: **Vyskocil, Jiri**
**Na Belidle 11**
**Praha(CS)**
Inventor: **Musil, Jindrich**
**Máchova 659**
**Revnice(CS)**

(74) Representative: **Patentanwälte Beetz sen. - Beetz jun. Timpe - Siegfried - Schmitt-Fumian- Mayr**
**Steinsdorfstrasse 10**
**W-8000 München 22(DE)**

(54) Method and device for evaporating an arc discharge cathode with cathode spots with reduced macroparticle emission.

(57) The inventive method and device relate to the fields of utilization in thin layer technologies and in ionic technologies. A reduction of macroparticle emission during the arc discharge cathode evaporating with cathode spots, whilst cathode material is evaporated from the cathode (1) evaporating surface in moving cathode spots in vacuum in the presence of a reactive or an inert gas, is attained by affecting the cathode evaporating surface by the reactive gas having a higher partial pressure than a critical pressure, while a plasma above the cathode evaporating surface is held electrically. The gist of the device consists in a structure of a cathode (1) formed of a cathode bottom (2) with an evaporating surface and of a cathode circumferential dam (3), which dam (3) is higher than 5 % of the cathode bottom (2) characteristic cross dimension.

FIG. 2

## METHOD AND DEVICE FOR EVAPORATING AN ARC DISCHARGE CATHODE WITH CATHODE SPOTS WITH REDUCED MACROPARTICLE EMISSION

The invention concerns a method and a device for evaporating an arc discharge cathode with cathode spots used e.g. during forming thin layers, and leads to a reduction of a macroparticle mixture, the presence of which in plasma flux causes an increase of thin layer surface roughness and, therefore, their quality reduction.

Hitherto well-known methods and devices for evaporating an arc discharge cathode utilize, for macroparticle separation from plasma flux, an ion deviation by means of a magnetic field, as stated by I. I. Akcenov et al., Pribory i technika eksperimenta 5, 1978, 236, or of an electrostatic field in accordance with JP 51-44705, while macroparticle motion is substantially rectilinear. Macroparticles are separated and catched on condensing surfaces. A further possibility of macroparticle separation is the utilizaton of rotating curtains, as stated by V. N. Cernjajev et al., Elektronnaja technika - Materialy, 5, 1980, 116. A common disadvantage of all separation systems is their considerable intricacy and maintenance-load, marked reduction of evaporated material utilization and, on top of it, it is difficult to ensure catching all macroparticles on the condensing surfaces.

For the reduction of macroparticle emission from catho des there have been designed systems that ensure an increase of cathode spots directed motion velocity in a magnetic field in accordance with US-A-4 673 477. A reduction of macroparticle emission in these systems only with high intensities of the magnetic field on cathode surface considerably restricts the maximum thickness of cathode. In addition to it, material evaporating occurs only on a very narrow path and, consequently, the coefficient of material utilization is low. For these reasons there have been proposed systems with intricate mechanical motion of magnetic circuit, stated e.g. in US-A-4 673 477, EP-B1-0 283 095, EP-B1-0 284 145. In a system utilizing a discharge in an auxiliary hollow cathode, specified in SU patent 894 018, for the reduction of the principal arc discharge current between cathode and anode, there is also attained a partial reduction of macroparticles emission. However, formed layers can be contaminated by material of the auxiliary hollow cathode. An evaporating system having a conical cathode with a cavity directed towards the anode and a hole on the substrate side in accordance with SU patent 901 357, has a low efficiency, because the main flux of the evaporated particles is directed towards the anode.

Disadvantages of the well-known methods are overcome by the method of evaporating an arc discharge cathode with cathode spots with reduced macroparticle emission according to the present invention, wherein cathode material is evaporated from the cathode evaporating surface in moving cathode spots in vacuum in the presence of a reactive or an inert gas. The gist of the invention consists in affecting the evaporating cathode surface by the reactive gas with a partial pressure higher than a critical one, while plasma is electrically held above the cathode evaporating surface. The cathode spots and plasma are, in accordance with the invention, further affected above the cathode evaporating surface by a magnetic field.

The application of the method in accordance with the invention increases the number and velocity of cathode spots motion, and, therefore, a lower local thermal load of the cathode surface in cathode spots occurs and the arc discharge on the cathode proceeds to a mode with a suppressed macroparticle emission. The magnetic field affects the trajectory and velocity of cathode spots on the evaporating surface and increases the ionization of gas and metal particles. The magnetic field intensity can affect the critical pressure magnitude of the reactive gas.

The gist of the device for carrying out method according to the invention, comprising a cathode placed in a cooled cathode block and an anode variant in principle, consists in that the cathode is formed of two parts, whereof one part is formed by the cathode bottom with an evaporating surface and the other part is formed by a cathode circumferential dam. The dam is higher than 5 % of the characteristic cross dimension of the cathode bottom. The advantage of this variant consists in that the electric field, formed by the circumferential dam and the cathode bottom, holds the plasma near to the evaporating surface, i.e. the cathode bottom. According to a further advantageous embodiment with the application of a cathode with a large evaporating surface there is formed in the cathode bottom a system of lugs, the height of which surpasses 5 % of their minimum mutual distance. The lugs may be a part of a cooled cathode block, whilst in the cathode bottom there are formed holes corresponding to the lugs, which simplifies the structure of the cathode evaporating bottom. In order to ensure a constant mutual position of the cathode bottom evaporating surface and the dam or lugs even during a long-term operation and, therefore, with an important material loss from the cathode bottom evaporating surface, the cathode bottom is provided in sliding relation towards the dam and lugs. Making the cathode bottom and the dam of the same material results in a simple structure in order to keep the electric holding plasma near to the cathode bottom evaporating surface. In accordance with a further advantageous embodiment, the dam and/or lugs are made of a material with a higher cathode voltage drop than that of the cathode bottom material. The cathode spots move first across the material with a lower cathode voltage drop and, therefore, the evaporation of the circumferential dam and/or lugs is suppressed. In an alternative embodiment, the dams and/or lugs are formed of ferromagnetic material. In this case the cathode spots are re pelled from the ferromagnetic material by the induced magnetic field, whilst the evaporation of the dams and/or lugs is suppressed and the cathode spots are held on the evaporating surface of the cathode bottom. In order to keep a sufficient electric holding plasma above the evaporating surface of the cathode bottom, the dams and lugs are in electric contact with the cathode bottom. In accordance with a further alternative embodiment, the dams and/or lugs are electrically insulated from the cathode bottom. An advantage of this embodiment consists in an independent selection of the dam potential that can improve holding the plasma above the evaporating surface of the cathode bottom and prevent the cathode spots from transition on the dams and lugs. In order to affect the motion of cathode spots and plasma above the cathode evaporating surface, the cathode is equipped with a magnetic field source.

Advantages of the method and the device in accordance with the invention are realized especially in its application for technologies of thin layers. The reduction of the macroparticles content during the formation of thin layers greatly improves their properties, especially homogeneity, surface roughness, corrosion resistance and reflectivity. It is important for a variety of practical applications in the field of mechanical engineering (reduction of friction coefficient, reduction of abrasive wear), in chemical industry (increase of corrosion resistance), in microelectronics (reduction of defects, increase of conductance), in the application for forming decorative coatings etc. An important reduction of the macroparticle emission enables an effective utilization of the arc discharge with cathode spots as intensive source of ions for ionic technologies, e.g. implantations, ionic nitriding, ionic dust removal and etching and ionic micromechanical working.

The gist of the invention is illustrated in the drawings, where Fig. 1 graphically represents the affection of the cathode in various embodiments by the partial pressure of a reactive gas, Figs. 2, 3, 4 and 5 represent in sectional views various structural embodiments of cathodes, and Fig. 6 schematically represents a device for coating layers on substrates by evaporation of an arc discharge cathode with cathode spots. An example of the method according to the invention is given in connection with the description of the device function illustrated in Fig. 6.

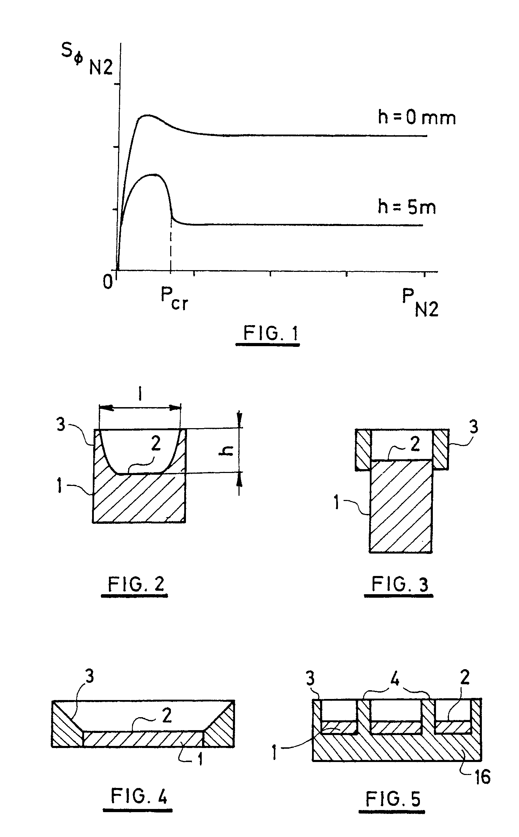

Fig. 1 graphically represents curves of sorbed flow rate

$$^s\phi_{N_2}$$

of a reactive gas, i.e. $N_2$ nitrogen, in dependence on the partial pressure

$$p_{N_2}$$

of nitrogen for a titanium cathode. In case of a flat cathode without dams and lugs, which is expressed by marking the respective curve h = 0 mm, the curve has a characteristic course with a non-conspicuous maximum. This course is given by two principal processes that take place during reactive evaporating: by a sorption of the reactive gas in a condensing layer on substrates and inner walls of the vacuum chamber and by a gentle reduction of the evaporation velocity from the cathode owing to the formation of a chemical compound on the evaporating surface of the cathode. Another situation occurs in case of application of a cathode that is equipped with a dam according to the invention, with a height h = 5 mm above the cathode bottom with a characteristic cross dimension 1 = 50 mm. The height h of the dam is made, consequently, 0.1 of the cathode characteristic cross dimension. The course of this curve, marked h = 5 mm, in the range of low partial pressures of reactive gas

$$p_{N_2} < p_{cr}$$

is substantially like the course of the curve for h = 0 mm. However in case of a critical pressure $p_{cr}$ an intense drop of

$$^s\phi_{N_2}$$

occurs that is caused by a transition of the arc discharge in a regime with suppressed emission of macroparticles. In such a regime occurs a reduction of the whole evaporation velocity and, consequently, a reduction of the gas sorption in the condensing layer. In case of a pressure

$$P_{N_2} > P_{cr}$$

the arc discharge in a regime with suppressed emission of macroparticles occurs which favourably influences the quality of a layer coated on substrates. The critical pressure $P_{cr}$ is, with given deposition conditions, determined from the rapid drop of the sorbed nitrogen flow rate. The qualitative course of dependence

$$s\phi_{N_2} \text{ on } P_{N_2}$$

and, consequently, also the transition of the arc discharge into the regime with depressed emission of macroparticles does not depend on the presence of the inert gas until a partial pressure of a dozen Pa.

Fig. 2 represents the principal structure of a cathode 1 in accordance with the invention, consisting of two parts. The one part is formed by the bottom 2 of the cathode 1 with an evaporating surface, and the other part is formed by a circumferential dam 3. The cathode 1 has a characteristic cross dimension 1 and the dam 3 has a height h. The dam 3 with its potential holds electrically the plasma above the evaporating surface of the cathode 1.

Fig. 3 represents a cathode 1 slidable mounted in a dam 3 in a direction normal to the surface of the cathode bottom 2. A loss of material evaporated on the bottom 2 of the cathode 1 is compensated by feeding the whole cathode 1 into the required position. Both the cathode 1 and the dam 3 may be made of the same material, or the dam 3 may be made of a material with a higher cathode drop than the material of the cathode bottom 2, or the dam 3 may be formed of a ferromagnetic material. The dam 3 can be either in electric contact with the cathode 1 or insulated from the cathode 1.

Fig. 4 represents a cathode 1 formed by a flat body, e. g. a disk, and is mounted into a circumferential dam 3, so that the bottom 2 of the cathode 1 is firmly connected to the dam 3. This arrangement is suited especially for large-surface cathodes 1 with a slow loss of material caused by evaporation of the bottom 2.

Fig. 5 represents an embodiment suited especially for large-size cathodes. The bottom 2 of the cathode 1 is equipped with lugs 4 that are a part of a cooled cathode block 16, whilst in the bottom 2 of the cathode 1 there are formed holes corresponding to the lugs 4.

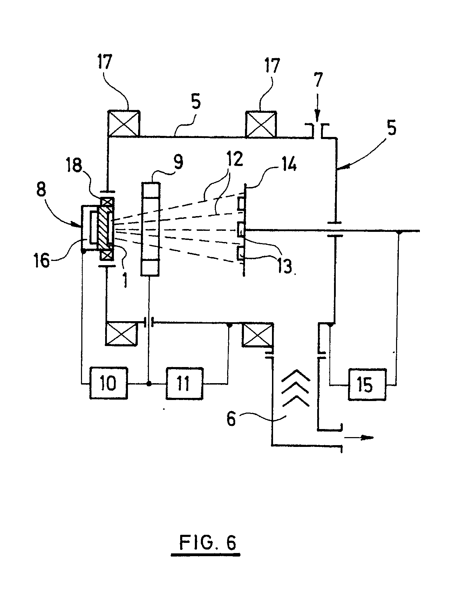

Fig. 6 represents a device for coating layers on substrates that consists of a vacuum chamber 5 with a vacuum pump 6 and a working gas supply 7. On a wall of the vacuum chamber 5 there is accommodated a device 8 for evaporation of the arc discharge cathode 1 with reduced emission of macroparticles. The dish-shaped cathode 1 is fixed in a cooled cathode block 16 that draws off heat liberated on the cathode during arc discharge. The cathode 1 is attached to a supply source 10. An auxiliary source 11 holds a voltage between an anode 9 and the metallic wall of the vacuum chamber 5. Also the walls of the metallic vacuum chamber 5 or even substrates 13 may be utilized as anodes. For affecting the motion of ions 12 in the space of the vacuum chamber 5 it is possible to form a magnetic field by means of coils 17. The substrates 13 for coating layers are fastened on a carrier 14 that has a potential of a bias source 15. The cathode 1 is equipped with a source 18 of magnetic field, formed by a magnetic system with an electromagnet or permanent magnets.

The operation of the device is explained in an actual example of the method in accordance with the invention for forming a titanium nitride layer. The circular cathode 1 of 50 mm diameter with a circumferential dam 3 of 5 mm height has been made of titanium. Nitrogen has been used as reactive gas. The substrates 13 have been placed on the carrier 14 in 150 mm distance. The arc discharge current was 75 A, the reactive gas pressure was held at 0.5 Pa during the deposition. A titanium nitride layer of about 4 $\mu$m thickness was coated on the metallographically polished substrates 13 with a velocity of about 0.1 $\mu$m $\cdot$ min$^{-1}$. The formed titanium nitride layer had a surface roughness of about 0.05 Ra. For comparison, titanium nitride layers of the same thickness formed with hitherto well-known methods have a roughness of a higher order about 0.5 Ra.

## Claims

1. Method of evaporating an arc discharge cathode with cathode spots with reduced macropar ticle emission, wherein cathode material is evaporated from the cathode evaporating surface in moving cathode spots in vacuum in presence of a reactive or an inert gas, characterized in that the evaporating cathode surface is affected by the reactive gas with a partial pressure higher than a critical one, while plasma is electrically held above the cathode evaporating surface.

2. Method according to claim 1, characterized in that the cathode spots and plasma are affected above the cathode evaporating surface by a magnetic field.

3. Device for carrying out the method according to claim 1, comprising a cathode placed in a cooled cathode block and an anode, characterized in that the cathode (1) is formed of two parts, whereof one part is formed by the cathode bottom with an evaporating surface (2) and the other part is formed by a cathode circum ferential dam (3) that is higher than 5 % of the characteristic cross dimension of the cathode bottom.

4. Device according to claim 3, characterized in that in the cathode bottom (2) there is formed a system of lugs (4) higher than 5 % of their minimum mutual distance.

5. Device according to claims 3 and 4, characterized in that the lugs (4) form a part of a cathode block (16) and that in the cathode bottom (2) there are formed holes corresponding to the lugs (4).

6. Device according to claims 3 and 4, characterized in that the cathode bottom (2) is provided slidably against the cathode dam (3) and lugs (4).

7. Device according to claim 3, characterized in that the cathode bottom (2) and the cathode dam (3) are made of the same material and are firmly connected.

8. Device according to claims 3 and 4, characterized in that the dam (3) of the cathode (1) and/or the lugs (4) are made of a material with a higher cathode voltage drop than that of the cathode bottom (2) material.

9. Device according to claims 3 and 4, characterized in that the cathode dam (3) and/or the lugs (4) are formed of ferromagnetic material.

10. Device according to claims 3 and 4, characterized in that the dam (3) and the lugs (4) are in electric contact with the cathode bottom (2).

11. Device according to claims 3 and 4, chacracterized in that the dam (3) of the cathode (1) and/or the lugs (4) are electrically insulated from the cathode bottom (2).

12. Device according to claims 3 to 11, characterized in that the cathode (1) is equipped with a magnetic field source (18).

FIG. 1

FIG. 2

FIG. 3

FIG. 4

FIG. 5

FIG. 6